# EUROPÄISCHE PATENTSCHRIFT

(11) **EP 1 154 034 B1**
(45) Veröffentlichungstag und Bekanntmachung des Hinweises auf die Patenterteilung: **12.03.2008**
(21) Anmeldenummer: 01108662.6
(22) Anmeldetag: 06.04.2001
(51) Int. Cl.: C23C 14/22, C23C 28/00, C23C 14/02

(54) **Verfahren zur Herstellung einer verschleiss- und reibarmen Beschichtung auf Leichtmetallbauteilen**
Method for making a low wear low friction coating on light metal objects
Méthode pour obtenir un revêtement à faible frottement et résistant à l'usure sur un objet en métal léger

(30) Priorität: 11.05.2000 DE 10023122
(43) Veröffentlichungstag der Anmeldung: 14.11.2001
(73) Patentinhaber: Bayerische Motoren Werke Aktiengesellschaft, 80809 München (DE)
(72) Erfinder: Martin, Dieter, Dr., 85368 Wang (DE); Mielsch, Götz, 80992 München (DE); Stothard, Nigel, Dr., 81927 München (DE); Ziegele, Holger, 80992 München (DE)

(56) Entgegenhaltungen:
- WO-A-98/02596
- WO-A-99/27147
- US-A- 4 992 153
- MONAGHAN D P ET AL: "DEPOSITION OF WEAR RESISTANT COATINGS BASED ON DIAMOND LIKE CARBON BY UNBALANCEDMAGNETRON SPUTTERING" SURFACE AND COATINGS TECHNOLOGY, ELSEVIER, AMSTERDAM, NL, Bd. 1-3, Nr. 60, 8. Oktober 1993 (1993-10-08), Seiten 525-530, XP001069796 ISSN: 0257-8972

## Beschreibung

Die Erfindung bezieht sich auf ein Verfahren zur Herstellung einer verschleiß- und reibarmen Beschichtung auf Leichtmetallbauteilen durch physikalische Dampfphasen-Abscheidung (PVD).

Zur Herstellung verschleiß- und reibarmer Schichten auf Bauteilen, z.B. für den Motor, stehen unterschiedliche PVD-Verfahren zur Verfügung. So können z.B. das Magnetronsputter-Verfahren und das lasergesteuerte Vakuumbogenentladungsverdampfungsverfahren (Laser-Arc-Verfahren) eingesetzt werden.

Bei dem Magnetronsputter-Verfahren wird zwischen einer ebenen Platte (auch Target genannt) und in der Regel dem Gehäuse der Vakuumbeschichtungskammer eine elektrische Spannung angelegt. Wird die Vakuumbeschichtungskammer mit Gas eines definierten Gesamtflusses durchströmt, so zündet vor dem Target ein Plasma. Ionen aus dem Plasma werden wegen des elektrischen Feldes auf das Target (Kathode) beschleunigt und schlagen aus diesem Atome heraus, die auf den gegenüber dem Target angeordneten Bauteilen kondensieren. Eine spezielle Anordnung von Magneten hinter dem Target steigert die Effizienz des Verfahrens.

In einer Vakuumbeschichtungskammer zum Magnetronsputtern können z.B. vier jeweils um 90° versetzte Magnetrons montiert sein (Surface and Coatings Technology, 60 (1993) 525-530).

Wenn die Targets aus Titan bestehen und als Prozeßgas zunächst Argon zugeführt wird, bildet sich auf dem Bauteil zuerst eine Titanschicht, bei Zufuhr von Stickstoff anschließend eine Titannitridschicht, bei Zufuhr eines Gemisches von Stickstoff und Acetylen oder anderen Kohlenwasserstoffgasen eine Titancarbonitridschicht und, wenn nur noch Acetylen oder andere Kohlenwasserstoffgase zugeführt werden. Hierbei werden freie Kohlenstoffvalenzen durch Wasserstoff abgesättigt.

Beim lasergesteuerten Vakuumbogenentladungsverdampfungsverfahren (oder kurz: Laser-Arc-Verfahren) trifft ein gepulster Lichtstrahl aus einem Infrarotlaser durch eine Glasscheibe auf eine in einer Vakuumanlage angeordnete, rotierende, aus einem leitfähigen Material bestehende Walze auf und induziert am Auftreffpunkt des Lasers auf die Walze ein Laserplasma, das durch eine im Abstand von bis zu 50 mm von der Walze angeordneten Elektrode und eine elektrische Spannung zwischen Walze und Elektrode ein sog. Bogenplasma bildet. Hierdurch werden Atome aus der. Walzenoberfläche ausgelöst, die im Bogenplasma nachionisiert werden. Diese Ionen erfahren im elektrischen Feld zwischen der Walze (Kathode) und der Elektrode (Anode) eine Beschleunigung und treffen anschließend auf die Bauteile in der Vakuumbeschichtungskammer, die mit dem Walzenmaterial beschichtet werden sollen.

Zur Abscheidung von Mehrfachschichten können an die Vakuumbeschichtungskammer mehrere Vorkammern mit jeweils einer Walze aus unterschiedlichem Material anschließbar sein, z.B. aus Aluminium oder Elektrodengraphit. Eine solche Anlage ist in WO 98/02596 beschrieben.

Ferner ist es aus WO 98/02596 bekannt, bei der vorstehend beschriebenen Magnetronsputter-Anlage mit vier jeweils um 90° versetzten Magnetrons ein Magnetron durch eine Quelle, zu ersetzen, die eine Kohlenstoffwalze für die lasergesteuerte Bogenentladungsverdampfung aufweist. Mit dem Magnetronsputter-Prozess kann auf das in der Kammermitte rotierend angeordnete Substrat ein Schichtsystem aus Metallen, Metallnitriden, Metallcarbonitriden oder Metallcarbiden, wie z.B. Ti, TiNₓ, TiCₓN_{y} oder TiCₓ-Einzelschichten aufgebracht werden. Anschließend wird durch lasergesteuerte Vakuumbogenentladungsverdampfung mit der Kohlenstoffwalze eine amorphe Kohlenstoffschicht definiert einstellbarer Härte aufgebracht.

Während sich sowohl nach dem Magnetronsputter-Verfahren wie nach dem lasergesteuerten Vakuumbogenentladungsverdampfungsverfahren Stahlbauteile für tribologische Anwendungen erfolgreich beschichten lassen, war es bisher nicht möglich, Bauteile aus Leichtmetallen, wie Aluminium, Magnesium oder Titan oder deren Legierungen, mit verschleiß- und reibarmen Hartstoffschichten durch Magnetronsputtern oder lasergesteuerte Vakuumbogenentladungsverdampfung zu versehen, auch nicht durch ein anderes PVD- oder CVD(Chemical Vapor Deposition)-Verfahren. Das Hauptproblem besteht in einer zu geringen Stützwirkung des Leichtmetalls für die für tribologische Einsatzbedingungen notwendigen Schichten mit z.T. sehr hohen Härteverten bei niedrigen Schichteigenspannungen. Auf der anderen Seite ist man bemüht, insbesondere im Fahrzeugbau zunehmend Leichtmetallbauteile einzusetzen.

Aufgabe der Erfindung ist es, ein Verfahren bereitzustellen, mit dem Leichtmetallbauteile mit verschleiß- und reibarmen Hartstoffschichten versehen werden können.

Dies wird erfindungsgemäß mit dem im Anspruch 1 gekennzeichneten Verfahren erreicht. In den Unteransprüchen sind vorteilhafte Ausgestaltungen des erfindungsgemäßen Verfahrens wiedergegeben.

Nach dem erfindungsgemäßen Verfahren können Leichtmetallbauteile mit einer Hartstoffschicht versehen werden, die tribologisch einwandfreie Eigenschaften aufweist, insbesondere eine einwandfreie Haftung, einen niedrigen Verschleißkoeffizienten und einen niedrigen Reibwert.

Unter Leichtmetallen sind dabei Metalle und Metalllegierungen mit einer Dichte von weniger als 5 gcm⁻³ zu verstehen (vgl. Römpps Chemie-Lexikon, 8. Auflage, Stichwort "Leichtmetalle"). Dazu gehören insbesondere Aluminium, Magnesium und Titan sowie deren Legierungen.

Nach der Erfindung werden zwei PVD-Verfahren kombiniert, um Leichtmetallbauteile zu beschichten. Das heißt, das Bauteil wird zuerst durch Magnetronsputtern mit einer Hartstoffschicht aus Metallcarbid, Metallnitrid, Metallcarbonitrid, Metallborid und/oder Metallsilicid versehen, wobei eine an das Bauteil angrenzende Teilschicht aus Metall besteht.

Auf diese erste, magnetrongesputterte Schicht wird dann durch lasergesteuerte Vakuumbogenentladungsverdampfung eine zweite Schicht aufgetragen, die mindestens aus einer Kohlenstoffschicht besteht. Erfindungsgemäß wird zwischen magnetrongesputterter Schicht und Laser-Arc-Kohlenstoffschicht eine haftvermittelnde Metallschicht abgeschieden. Um den Schichtverschluß weiter zu minimieren können alternativ mehrere Laser-Arc-Kohlenstoffschichten mit dazwischenliegenden Metallschichten abgeschieden werden.

Während z.B. Stahlbauteile, die durch Magnetronsputtern mit einer Hartstoffschicht versehen werden, einen geringen Reibwert aufweisen, besitzen Leichtmetallbauteile, die mit einer magnetrongesputterten Hartstoffschicht versehen sind, wegen des Schichtversagens bei geringen Belastungen einen wesentlich höheren Reibwert. Noch größer sind die Unterschiede bei durch lasergesteuerte Vakuumbogenentladungsverdampfung aufgetragene Schichten, aus alternierenden Metall- und Kohlenstoffschichten mit einer Metallschicht als innerster an das Bauteil angrenzenden Schicht und einer Kohlenstoffschicht außen. Hier zeichnen sich entsprechend beschichtete Stahlbauteile durch sehr niedrige Reibwerte und Verschleißkoeffizienten aus, während Leichtmetallbauteile, die mit einer durch lasergesteuerte Vakuumbogenentladungsverdampfung aufgebrachten Schicht aus alternierenden Metall- und Kohlenstoffschichten mit einer Kohlenstoffschicht außen einen völlig unbrauchbaren Reibwert und Verschleißkoeffizienten besitzen, bedingt durch das Schichtversagen wegen der fehlenden Stützwirkung des Substrats aus Leichtmetall.

Überraschenderweise wird jedoch auf Leichtmetallbauteilen dann eine Hartstoffschicht gebildet, die auch hinsichtlich des Reibwerts und des Verschleißkoeffizienten alle an mechanisch beanspruchte Bauteile zu stellenden Forderungen genügt, wenn, wie erfindungsgemäß vorgesehen, auf das Leichtmetallbauteil erst eine magnetrongesputterte Schicht teilweise aus einem Metall und teilweise aus Metallcarbid, Metallnitrid, Metallcarbonitrid, Metallborid und/oder Metallsilicid und auf die magnetrongesputterte Schicht dann eine zweite Schicht durch lasergesteuerte Bogenentladungsverdampfung aufgetragen wird, die aus alternierenden Metall-Kohlenstoffschichten besteht, und zwar mit einer Metallschicht als innerster Schicht und einer Kohlenstoffschicht außen.

Dies ist möglicherweise darauf zurückzuführen, dass Leichtmetalle ein relativ weiches metallisches Grundmaterial bilden, das, wenn es z.B. durch lasergesteuerte Vakuumbogenentladungsverdampfung mit einer Hartstoffschicht versehen wird, schon bei relativ geringer Belastung zu einem Schichtversagen führt, da das Leichtmetall für eine unzureichende Stützwirkung sorgt; vergleichbar mit einer stark belasteten dünnen Glasplatte, die auf einer Gummiunterlage ruht und bei Belastung bricht.

Die magnetrongesputterte Schicht der erfindungsgemäßen Schichtkombination besteht vorzugsweise aus mehreren Einzelschichten. Die innerste, an das Bauteil angrenzende Schicht wird aus einer Metallschicht gebildet. Die sich daran anschließenden Schichten können eine Carbid-, Nitrid-, Carbonitrid-, Borid- oder Silicid-Schicht dieses Metalls sein. Beispielsweise kann sich an die Metallschicht eine Nitrid-, eine Carbonitrid- und eine Carbidschicht dieses Metalls in dieser Reihenfolge anschließen.

Als Metall wird vorzugsweise ein Metall der Gruppe IV-A des Periodensystems, wie Titan, oder der Gruppe VI-A wie Chrom, Molybdän oder Wolfram verwendet, ggf. auch ein Metall der Gruppe V-A, beispielsweise Tantal oder Niob, gegebenenfalls auch ein Metall der Gruppe IIIb, wie Aluminium.

Die magnetrongesputterte Schicht kann mit einer Anlage hergestellt werden, wie sie in "Surface and Coating Technology", 60 (1993) 525-530 beschrieben ist. Die Targets werden durch eine Platte des aufzusputternden Metalls, beispielsweise Titan gebildet. Als Trägergas wird Argon oder ein anderes Prozeßgas verwendet.

Die Nitridschicht kann durch Zufuhr von Stickstoffgas in den Plasmareaktor gebildet werden. Die Ionen des Plasmas schlagen Metall - also beispielsweise Titanatome aus dem Target heraus, die zusammen mit den Stickstoffatomen oder -ionen des Plasmas das sich auf dem Bauteil abscheidende Metallnitrid bilden. Die Carbonitridschicht kann in gleicher Weise durch Zufuhr eines Gemisches aus Stickstoff und Acetylen oder einem anderen Kohlenwasserstoff, wie Methan, gebildet werden, die Carbidschicht nur durch Zufuhr des Kohlenwasserstoffs im Gemisch mit dem Prozeßgas.

Da die Zusammensetzung des Gases und damit des Plasmas kontinuierlich geändert werden kann, tritt auch eine kontinuierliche Änderung in der Zusammensetzung der Schicht auf, es wird eine sogenannte Gradientenschicht abgeschieden. Das heißt, wenn eine Carbonitridschicht zwischen einer Nitrid- und einer Carbidschicht gebildet wird, nimmt der Stickstoffanteil in der Carbonnitridschicht von der Nitridschicht zur Carbidschicht zunehmend ab.

Die Schichtdicke der magnetrongesputterten Schicht beträgt vorzugsweise 1 µm bis 20 µm. Unter 1 µm kommt die Oberflächenrauhigkeit des Bauteils zum Tragen, wodurch die magnetrongesputterte Schicht ihre Stützwirkung verliert. Über 20 µm wird keine weitere Verbesserung der tribologischen Eigenschaften erreicht. Besonders bevorzugt ist eine Schichtdicke der magnetrongesputterten Schicht von 2 µm bis 6 µm.

Die Reinigung der Bauteile vor dem Magnetronsputtern kann mit Lösungsmitteln oder mit alkalischen Reinigungsmitteln im Ultraschallbad erfolgen. Zur Entfernung der sich auf den Bauteilen nach der chemischen Reinigung bildenden Oxidschicht wird nach Einbau der Bauteile in die Vakuumkammer in dieser ein Plasma zum Sputterreinigen der Bauteile gezündet.

Zur Abscheidung der ersten Schicht in der Magnetronsputter-Anlage kann an das oder die Targets eine Gleichspannung, ggf. auch eine gepulste Gleichspannung oder eine RF-Spannung angelegt werden.

Die lasergesteuerte Bogenentladungsverdampfung im Anschluss an das Magnetronsputtern kann beispielsweise mit einer Anlage durchgeführt werden, wie sie in WO 98/02596 gezeigt und beschrieben ist. Die eine Walze ist dabei mit einem Metall versehen, um die wenigstens eine Metallschicht zu bilden, die andere mit Graphit, um die Kohlenstoffschicht zu bilden.

Zwar ist es möglich, eine Vakuumbeschichtungskammer zu verwenden, die wenigstens ein Target zum Magnetronsputtern und wenigstens eine Vorkammer für die Graphitwalze zur lasergesteuerten Vakuumbogenentladungsverdampfung nach dem Magetronsputtern ohne Unterbrechung des Vakuums erlaubt. Falls das Magnetrosputtern und die lasergesteuerte Bogenentladungsverdampfung jedoch in zwei getrennten Anlagen erfolgen, ist es zweckmäßig, die Oxidschicht, die sich beim Herausnehmen des mit dem Magnetronsputterverfahren beschichteten Bauteils aus der Magnetronsputter-Anlage bildet, vor der lasergesteuerten Vakuumbogenentladungsverdampfung zu entfernen. Dazu wird die Anlage zur lasergesteuerten Vakuumbogenentladungsverdampfung vorzugsweise mit einer Plasmastrahlquelle versehen, der Argon oder ein anderes Gas zugeführt wird, um ein Plasma zu bilden, das die Oberflächenoxidschicht beseitigt.

Das Metall zur Bildung der Metallschicht durch lasergesteuerte Vakuumbogenentladungsverdampfung ist vorzugsweise ein Metall der Gruppe III-B des Periodensystems, wie Aluminium, der Gruppe IV-A, wie Titan, der Gruppe V-A, wie Tantal oder Niob, oder der Gruppe VI-A, wie Chrom, Molybdän oder Wolfram.

Vorzugsweise besteht die durch lasergesteuerte Vakuumbogenentladungsverdampfung gebildete zweite Schicht aus mehreren abwechselnd angeordneten Metall- und Kohlenstoffschichten, wobei die innerste, an die magnetrongesputterte Schicht angrenzende, durch lasergesteuerte Vakuumbogenentladungsverdampfung erzeugte Teilschicht eine Metallschicht und die äußerste Schicht eine Kohlenstoffschicht ist.

Dabei können mehrere Metall- und Kohlenstoff-Schichten alternierend aufgebracht werden, insbesondere sind es 2 oder 3.

Die Dicke der einzelnen Metallschichten beträgt vorzugsweise maximal 100 nm, insbesondere 5 nm bis 30 nm, die der einzelnen Kohlenstoffschichten vorzugsweise 50 nm bis 1000 nm, insbesondere 200 nm bis 500 nm. Die Gesamtschichtdicke der durch lasergesteuerte Bogenentladungsverdampfung aufgebrachten Schicht beträgt vorzugsweise 100 nm bis 5 µm, vorzugsweise 500 nm bis 2 µm.

Durch die erfindungsgemäße Kombination einer Magnetronsputter-Schicht mit einer lasergesteuerten Vakuumbogenentladungsverdampfungsschicht können verschleißfestere Schichten mit einem gegenüber einer Einzelbeschichtung nochmals erniedrigten Reibwert auf Leichtmetallen erzeugt werden. Die magnetrongesputterte Schicht dient dabei auf dem Leichtmetallbauteil als Stützschicht für die verschleißfestere lasergesteuerte Vakuumbogenentladungsverdampfungsschicht. Die erfindungsgemäße Kombinationsschicht erlaubt so den Einsatz höherer Flächenpressungen. So kann die kritische Last Lc beim Ritztest wesentlich erhöht werden. Wegen des geringeren Verschleißes der erfindungsgemäßen Kombinationsschicht wird die Lebensdauer von mechanisch beanspruchten Leichtmetallbauteilen wesentlich verlängert.

Nach dem erfindungsgemäßen Verfahren können damit auch mechanisch beanspruchte Bauteile, die bisher nur aus Stahlwerkstoffen hergestellt werden konnten, aus Leichtmetall hergestellt werden, beispielsweise für Motoren, Getriebe oder Gleitlager. Damit kann insbesondere im Fahrzeugbau der Einsatz von Leichtmetallen wesentlich erweitert werden.

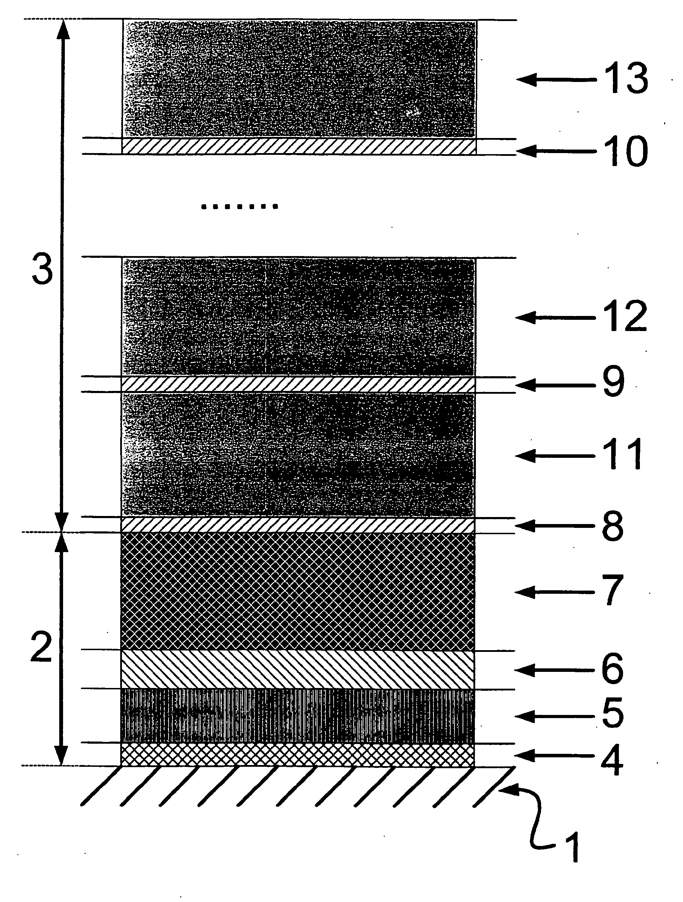

Nachstehend ist eine Ausführungsform der erfindungsgemäßen Beschichtung anhand der Zeichnung näher erläutert, deren einzige Figur schematisch einen Schnitt durch die Beschichtung zeigt.

Danach ist auf einem Bauteil 1 eine Schicht 2 durch Magnetronsputtern aufgetragen, und auf die magnetrongesputterte Schicht 2 eine zweite Schicht 3 durch lasergesteuerte Vakuumbogenentladungsverdampfung. Die erste Schicht 2 besteht aus einer Metallschicht 4, z.B. Ti, Cr oder W sowie einer Nitridschicht 5, einer Carbonitrid-Teilschicht 6 und einer Carbid-Schicht 7 dieses Metalls. Die Metallkarbid-Teilschicht 7 wird durch eine Metall-a-C:H-Schicht mit Metallgradient gebildet, d.h. eine Schicht, in der der amorphe Kohlenstoffanteil gegenüber dem Metall nach außen zunimmt, wobei die freien C-Valenzen durch Wasserstoff abgesättigt sind.

Die zweite Schicht 3 besteht aus alternierenden Metallschichten 8, 9, 10, z.B. Al, Ti, Ta, Cr oder W, und Kohlenstoffschichten 11, 12, 13.

Die nachstehenden Beispiele dienen der weiteren Erläuterung der Erfindung.

### Beispiel 1

In einer Magnetronsputter-Anlage gemäß dem erwähnten Artikel aus "Surface and Coatings Technology" mit vier um eine zylindrische Vakuumbeschichtungskammer angeordneten Titan-Targets und einem rotierenden Substrathalter wurden scheibenförmige Probekörper aus einer Aluminiumlegierung als zu beschichtende Bauteile gegeben, die vorher mit Lösungsmitteln im Ultraschallbad gewaschen worden sind.

Die Probekörper werden dann im wesentlichen entsprechend dem erwähnten Artikel aus "Surface and Coating Technology" in dieser Anlage beschichtet. Das heißt, unter Zufuhr von Argon bei einem Druck von 10⁻³ mbar wird an die Substrathalter eine Vorspannung von ca. -1000 V angelegt, um die Probekörper mit Hilfe eines Plasmas zu reinigen. Anschließend wird zur Abscheidung einer Titanmetallschicht eine Gleichspannung von ca. 300 V bis 400 V bei 6 A an die Targets angelegt, und an den Substrathalter eine Vorspannung von bis zu -100 V.

Nach fünf Minuten wird dem Argongas 20 Minuten lang Stickstoff zugemischt, um eine Titannitridschicht zu bilden. Unter Zufuhr eines Gemisches von Stickstoff, Acetylen und dem Argongasträger wird dann 20 Minuten lang eine TitancarbonitridSchicht abgeschieden, und anschließend innerhalb von weiteren 20 Minuten eine Ti-a-C:H-Schicht, also eine titanhaltige amorphe Kohlenstoffschicht mit durch Wasserstoff abgesättigten freien Kohlenstoff-Valenzen und kontinuierlich abnehmenden Titangehalt. Die Schichtdicke der so gebildeten magnetrongesputterten Schicht beträgt ca. 4 µm.

Ein Teil der Probenkörper wurde anschließend in die Vakuumbeschichtungskammer einer lasergesteuerten Bogenentladungsverdampfungsanlage gemäß WO 98/02596 gegeben, deren beide Quellenkammern mit einer walzenförmigen Kathode aus hochreinem Titan bzw. Elektrodengraphit versehen sind, und an die zusätzlich eine Plasmastrahlquelle angeflanscht ist.

Unter Zufuhr von Argon zur Plasmastrahlquelle werden bei einem Druck von 10⁻³ mbar der Substrathalter und die daran befestigten Probenkörper mit einem Plasmastrahl hoher Energie und Stromdichte beschossen, um die Oberflächenoxidschicht auf der magnetrongesputterten Schicht zu entfernen.

Die Beschichtungskammer wird dann auf 10⁻⁵ mbar evakuiert, und mit einem gepulsten Laserstrahl (Nd-YAG-Laser, Wellenlänge 1,06 µm, Impulslänge 90 ns, Impulsenergie > 15 mJ, Leistungsdichte im Focus > 5 x 10⁸ Wcm⁻²) wird zuerst auf der rotierenden walzenförmigen Titankathode durch achsparallele hin- und hergehende Bewegung des Laserstrahls ein Laserplasma gezündet. Die Kathode und Anode sind mit einer gepulsten Stromquelle verbunden, so daß ein Bogenplasma gezündet werden kann, in dem ein maximaler Bogenstrom von 1,5 kA bei einer Brennspannung von ca. 60 V fließt. Diese Anlagenparameter bleiben so lange unverändert, bis die Dicke der Titanschicht am Probekörper ca. 20 nm beträgt. Anschließend wird unter vergleichbaren Bedingungen die Graphitkathode mit dem Laserstrahl bestrahlt, um eine Kohlenstoffschicht mit einer Dicke von 400 nm zu bilden. Dieser Vorgang wird wiederholt, sodass eine Schichtfolge aus jeweils zwei sich abwechselnden Titanschicht und Kohlenstoffschichten gebildet wird, mit einer Titanschicht als innerster und einer Kohlenstoffschicht als äußerster Schicht. Die Gesamtschichtdicke der durch lasergesteuerte Vakuumbogenentladungsverdampfung gebildeten Schicht beträgt etwa 1 µm.

Von den durch kombiniertes Magnetronsputtern und lasergesteuertes Vakuumbogenentladungsverdampfen beschichteten Probekörpern wurde die Mikrohärte der Beschichtung sowie deren Haftung, Reibwert und Verschleißkoeffizient bestimmt. Die Bestimmung der Haftung erfolgte nach dem Rockwell-Test (VDI-Richtlinie 3198/1991), wonach HF1 "eine sehr gute", HF2 "eine gute" und z.B. HF6 "eine ungenügende Haftung" der Schicht bedeuten. Die Reibwerte wurden im ungeschmierten Zustand unter normalen Laborbedingungen (25% relative Feuchte, 22°C) mit Linearhüben über 5 mm mit einer 100Cr-6-Kugel als Gegenkörper und mit einer Flächenpressung von 300 Nmm⁻² bestimmt. Die Summe der Verschleißvolumina von Kugel und beschichtetem Probekörper wird normiert, auf die Flächenpressung und die Verschließspurlänge und anschließend als sogenannter Verschleißkoeffizient angegeben.

Die Ergebnisse sind in der nachstehenden Tabelle 1 angegeben.

### Beispiel 2 (Vergleich)

Bei einem Teil der Probekörper erfolgte die Bestimmung der Mikrohärte der Beschichtung sowie deren Haftung, Reibwert und Verschleißkoeffizient unmittelbar nach dem Magnetronsputtern, d.h. sie wurden keiner lasergesteuerten Bogenentladungsverdampfung unterworfen. Die Ergebnisse sind in der nachstehenden Tabelle 1 angegeben.

### Beispiel 3 (Vergleich)

Statt magnetrongesputterter Probekörper wurden in die lasergesteuerte Vakuumbogenentladungsverdampfungs-Anlage Probekörder gegeben, die vorher lediglich mit einem Lösungsmittel im Ultraschallbad gereinigt worden sind. Diese Probekörper wurden dann in gleicher Weise einer lasergesteuerten Vakuumbogenentladungsverdampfung unterworfen, wie in Beispiel 1 beschrieben. Die Ergebnisse sind in der nachstehenden Tabelle 1 angegeben. Zudem war ein Versagen unter Belastung festzustellen.

### Beispiel 4, 5 und 6 (Vergleich)

Die Beispiele 1, 2 und 3 wurden wiederholt, jedoch wurden statt Probekörpern aus einer Aluminiumlegierung Stahlscheiben verwendet. Außerdem wurden die Reibwerte bei einer Flächenpressung von 950 Nmm⁻² ermittelt. Die Ergebnisse sind in der nachstehenden Tabelle 2 zusammengefaßt.

Wie aus Tabelle 1 hervorgeht, weist die erfindungsgemäße Kombinationsschicht eine hohe Härte, gute Haftung und einen so niedrigen Verschleißkoeffizienten wie die Magnetronsputter-Schicht auf, insbesondere aber einen Reibwert, der wesentlich niedriger ist als der Reibwert der Magnetronsputter-Schicht oder der Laser-Arc-Schicht, sodass hinsichtlich des Reibwertes ein überadditiver Effekt festzustellen ist. Demgegenüber geht aus der Tabelle 2 hervor, dass bei der Kombinationsschicht auf Stahl die Werte der zuletzt aufgetragenen Laser-Arc-Schicht entsprechen.

**Tabelle 1**

| Beschichtete Probekörper aus einer Aluminiumlegierung | | | |
|---|---|---|---|
| **Beispiel** | **Beispiel 1** | **Beispiel 2** | **Beispiel 3** |
| | **(Erfindung)** | **(Vergleich)** | **(Vergleich)** |
| | **Kombinationsschicht** | **Magnetronsputter-Schicht** | **Laser-Arc-Schicht** |
| **Härte [GPa]** | 40 | 20 | 50 |
| **HF-Klasse** | 2 | 2 | 2 |
| **Reibwert** | 0,17 | 0,27 | 0,45 |
| **Verschleißkoeffizient [mm³N⁻¹m⁻¹]** | 1,5 · 10⁻⁶ | 1,5 · 10⁻⁶ | 8,2 · 10⁻⁴ |

**Tabelle 2**

| Beschichtete Probekörper aus Stahl | | | |
|---|---|---|---|
| **Beispiel** | **Beispiel 4** | **Beispiel 5** | **Beispiel 6** |
| | **(Vergleich)** | **(Vergleich)** | **(Vergleich)** |
| | **Kombinationsschicht** | **Magnetronsputter-Schicht** | **Laser-Arc-Schicht** |
| **Härte [Gpa]** | 40 | 20 | 50 |
| **HF-Klasse** | 2 | 1 | 2 |
| **Reibwert** | 0,13 | 0,20 | 0,13 |
| **Verschleißkoeffizient [mm³N⁻¹m⁻¹]** | 1 · 10⁻⁷ | 7 · 10⁻⁷ | 1 · 10⁻⁷ |

## Patentansprüche

1. Verfahren zur Herstellung einer verschleiß- und reibarmen Beschichtung auf Leichtmetallbauteilen (1), wobei unter Leichtmetallen Metalle und Metalllegierungen mit einer Dichte von weniger als 5 gcm⁻³ zu verstehen sind, durch Auftragen einer Schicht (3) durch lasergesteuerte Vakuumbogenentladungsverdampfung, die aus mindestens einer Kohlenstoffschicht (11, 12, 13) und einer haftvermittelnden Metallschicht (8) besteht, **dadurch gekennzeichnet, dass** auf das Bauteil (1) eine erste Schicht (2) aus einer an das Bauteil (1) angrenzenden Teilschicht (4) aus Metall und wenigstens einer weiteren Teilschicht aus Metallcarbid, Metallnitrid, Metallcarbonitrid, Metallborid und/oder Metallsilicid durch Magnetronsputtern und auf die erste, magnetrongesputterte Schicht (2) die Schicht (3) durch lasergesteuerte Vakuumbogenentladungsverdampfung als zweite Schicht aufgetragen wird, wobei die haftvermittelnde Metallschicht (8) der zweiten Schicht (3) zwischen magnetrongesputterten Schicht (2) und der wenigstens einen durch lasergesteuerte Vakuumbogenentladungsverdampfung aufgetragenen Kohlenstoffschicht (11, 12, 13) abgeschieden wird.

2. Verfahren nach Anspruch 1, **dadurch gekennzeichnet, daß** die zweite Schicht (3) eine an die magnetrongesputterte Schicht (2) angrenzende Schicht (8) aus Metall und eine äußere, zuletzt abgeschiedene Schicht (13) aus Kohlenstoff aufweist.

3. Verfahren nach einem der Ansprüche, **dadurch gekennzeichnet, dass** die äußere, zuletzt durch Magnetronsputtern aufgetragene Schicht (7) aus Metallcarbid, Metallnitrid, Metallborid oder Metallsilicid, gegebenenfalls auch Kohlenstoff, besteht.

4. Verfahren nach Anspruch 2 und 3, **dadurch gekennzeichnet, dass** zwischen der an das Bauteil (1) angrenzenden Schicht (4) aus Metall und der äußeren Schicht (7) mehrere unterschiedliche Schichten (5) aus der Gruppe: Metallcarbid, Metallnitrid, Metallcarbonitrid, Metallborid und Metallsilicid aufgebracht werden.

5. Verfahren nach Anspruch 1, **dadurch gekennzeichnet, dass** das Metall der an das Bauteil (1) angrenzenden Schicht (4) und das Metall der Metallcarbid-, Metallnitrid-, Metallcarbonitrid-, Metallborid- und/oder Metallsilicid-Schicht ein Metall der Gruppe III-B, IV-A, V-A oder VI-A des Periodensystems ist.

6. Verfahren nach Anspruch 5, **dadurch gekennzeichnet, daß** das Metall der Gruppe III-B Aluminium ist.

7. Verfahren nach Anspruch 5, **dadurch gekennzeichnet, dass** das Metall der Gruppe IV-A Titan ist.

8. Verfahren nach Anspruch 5, **dadurch gekennzeichnet, daß** das Metall der Gruppe V-A Tantal ist.

9. Verfahren nach Anspruch 5, **dadurch gekennzeichnet, dass** das Metall der Gruppe VI-A Chrom, Molybdän oder Wolfram ist.

10. Verfahren nach einem der vorstehenden Ansprüche, **dadurch gekennzeichnet, dass** die erste, magnetrongesputterte Schicht (2) eine Schichtdicke von mindestens 1 µm aufweist.

11. Verfahren nach einem der vorstehenden Ansprüche, **dadurch gekennzeichnet, dass** die erste, magnetrongesputterte Schicht (2) eine Schichtdicke von höchstens 20 µm aufweist.

12. Verfahren nach einem der vorstehenden Ansprüche, **dadurch gekennzeichnet, dass** die durch lasergesteuerte Bogenentladungsverdampfung aufgebrachte, zweite Schicht (3) aus mehreren abwechselnd angeordneten Metallschichten (8, 9, 10) und Kohlenstoffschichten (11, 12, 13) besteht.

13. Verfahren nach einem der vorstehenden Ansprüche, **dadurch gekennzeichnet, dass** das Metall der wenigstens einen Metallschicht (8, 9, 10) der durch lasergesteuerte Bogenentladungsverdampfung aufgetragenen, zweiten Schicht (3) ein Metall der Gruppe III-B, IV-A, V-A oder VI-A des Periodensystems ist.

14. Verfahren nach Anspruch 13, **dadurch gekennzeichnet, dass** das Metall der Gruppe III-B Aluminium ist.

15. Verfahren nach Anspruch 13, **dadurch gekennzeichnet, dass** das Metall der Gruppe IV-A Titan ist.

16. Verfahren nach Anspruch 13, **dadurch gekennzeichnet, dass** das Metall der Gruppe V-A Tantal ist.

17. Verfahren nach Anspruch 13, **dadurch gekennzeichnet, dass** das Metall der Gruppe VI-A Chrom, Molybdän oder Wolfram ist.

18. Verfahren nach einem der vorstehenden Ansprüche, **dadurch gekennzeichnet, dass** die durch lasergesteuerte Bogenentladungsverdampfung aufgetragene, zweite Schicht (3) eine Schichtdicke von wenigstens 50 nm aufweist.

19. Verfahren nach einem der vorstehenden Ansprüche, **dadurch gekennzeichnet, dass** die durch lasergesteuerte Bogenentladungsverdampfung aufgetragene, zweite Schicht eine Schichtdicke von höchstens 5 µm aufweist.

20. Verfahren nach einem der vorstehenden Ansprüche, **dadurch gekennzeichnet, dass** das zu beschichtende Leichtmetallbauteil (1) aus Aluminium, Magnesium oder Titan oder einer Aluminium-, Magnesium- oder Titan-Legierung besteht.

## Claims

1. A method of producing a wear-resistant, friction-resistant coating on light-metal components (1) wherein "light metals" stands for metals and metal alloys with a density of less than 5 g/cm⁻³, by applying a layer (3) by laser-controlled vacuum arc-discharge evaporation, the layer comprising at least one carbon film or layer (11, 12, 13) and an adhesion-promoting metal layer (8), **characterised in that** the component (1) is coated with a first layer (2) comprising a metal part-layer (4) adjoining the component (1) and at least one additional part-layer of metal carbide, metal nitride, metal carbonitride, metal boride and/or metal silicide by magnetron sputtering and the first magnetron-sputtered layer (2) is coated with a second layer (3) by laser-controlled vacuum arc-discharge evaporation, wherein the adhesion-promoting metal layer (8) in the second layer (3) is deposited between the magnetron-sputtered layer (2) and the at least one carbon layer (11, 12, 13) deposited by laser-controlled vacuum arc-discharge evaporation.

2. A method according to claim 1, **characterised in that** the second layer (3) comprises a metal layer (8) adjoining the magnetron-sputtered layer (2) and also comprises an outer, finally deposited layer (13) of carbon.

3. A method according to any of the claims, **characterised in that** the outer layer (7) finally deposited by magnetron sputtering comprises metal carbide, metal nitride, metal boride or metal silicide, or optionally carbon also.

4. A method according to claims 2 and 3, **characterised in that** a number of different layers (5) from the group: metal carbide, metal nitride, metal carbonitride, metal boride and metal silicide are deposited between the outer layer (7) and the metal layer (4) adjoining the component (1).

5. A method according to claim 1, **characterised in that** the metal in the layer (4) adjoining the component (1) and the metal in the metal carbide, metal nitride, metal carbonitride, metal boride and/or metal silicide layer is a metal in the group III-B, IV-A, V-A or VI-A in the periodic system.

6. A method according to claim 5, **characterised in that** the group lll-B metal is aluminium.

7. A method according to claim 5, **characterised in that** the group IV-A metal is titanium.

8. A method according to claim 5, **characterised in that** the group V-A metal is tantalum.

9. A method according to claim 5, **characterised in that** the metal in group VI-A is chromium, molybdenum or tungsten.

10. A method according to any of the preceding claims, **characterised in that** the first magnetron-sputtered layer (2) has a thickness of at least 1µm.

11. A method according to any of the preceding claims, **characterised in that** the first magnetron-sputtered layer (2) has a thickness of not more than 20 µm.

12. A method according to any of the preceding claims, **characterised in that** the second layer (3), deposited by laser-controlled arc-discharge evaporation, comprises a number of metal layers (8, 9, 10) alternating with carbon layers (11, 12, 13).

13. A method according to any of the preceding claims, **characterised in that** the metal in the at least one metal layer (8, 9, 10) in the second layer (3) deposited by laser-controlled arc-discharge evaporation is a metal in group III-B, IV-A, V-A or VI-A in the periodic system.

14. A method according to claim 13, **characterised in that** the group III-B metal is aluminium.

15. A method according to claim 13, **characterised in that** the group IV-A metal is titanium.

16. A method according to claim 13, **characterised in that** the group V-A metal is tantalum.

17. A method according to claim 13, **characterised in that** the group VI-A metal is chromium, molybdenum or tungsten.

18. A method according to any of the preceding claims, **characterised in that** the second layer (3) deposited by laser-controlled arc discharge evaporation has a thickness of at least 50 nm.

19. A method according to any of the preceding claims, **characterised in that** the second layer deposited by laser-controlled arc discharge evaporation has a thickness of not more than 5 µm.

20. A method according to any of the preceding claims, **characterised in that** the light-metal component (1) for coating is of aluminium, magnesium, titanium or an aluminium, magnesium or titanium alloy.

## Revendications

1. Procédé pour obtenir un revêtement à faible friction et résistant à l'usure sur des éléments en métal léger (1), les métaux légers étant des métaux et des alliages métalliques d'une densité inférieure à 5 gcm⁻³, par application d'une couche (3) par évaporation à décharge d'arc sous vide commandée par laser, qui comprend au moins une couche en carbone (11, 12, 13) et une couche métallique adhésive (8),
**caractérisé en ce qu'**
on applique sur l'élément (1) une première couche (2) comprenant une couche partielle (4) en métal adjacente à l'élément (1) et au moins une autre couche partielle en carbure métallique, nitrure métallique, carbonitrure métallique, borure métallique et/ou silicium métallique par vaporisation par magnétrons, puis, sur la première couche (2) vaporisée par magnétrons, on applique la couche (3) par évaporation à décharge d'arc sous vide commandée par laser servant de deuxième couche, la couche métallique (8) adhésive de la deuxième couche (3) étant déposée entre la couche vaporisée par magnétrons (2) et au moins une couche en carbone (11, 12, 13) appliquée par évaporation à décharge d'arc sous vide commandée par laser.

2. Procédé selon la revendication 1,
**caractérisé en ce que**
la deuxième couche (3) présente une couche (8) en métal adjacente à la couche (2) vaporisée par magnétrons et une couche (13) extérieure en carbone déposée en dernier lieu.

3. Procédé selon l'une des revendications 1 ou 2,
**caractérisé en ce que**
la couche (7) extérieure déposée en dernier lieu par vaporisation par magnétons est en carbure métallique, nitrure métallique, borure métallique ou silicium métallique, le cas échéant également en carbone.

4. Procédé selon les revendications 2 et 3,
**caractérisé en ce qu'**
entre la couche (4) en métal adjacente à l'élément (1) et la couche extérieure (7) sont appliquées plusieurs couches (5) différentes appartenant au groupe : carbure métallique, nitrure métallique, carbonitrure métallique, borure métallique et silicium métallique.

5. Procédé selon la revendication 1,
**caractérisé en ce que**
le métal de la couche (4) adjacente à l'élément (1) et le métal de la couche en carbure métallique, nitrure métallique, carbonitrure métallique, borure métallique et/ou silicium métallique est un métal du groupe III-B, IV-A, V-A ou VI-A de la classification périodique des éléments.

6. Procédé selon la revendication 5,
**caractérisé en ce que**
le métal du groupe III-B est de l'aluminium.

7. Procédé selon la revendication 5,
**caractérisé en ce que**
le métal du groupe IV-A est du titane.

8. Procédé selon la revendication 5,
**caractérisé en ce que**
le métal du groupe V-A est du tantale.

9. Procédé selon la revendication 5,
**caractérisé en ce que**
le métal du groupe VI-A est du chrome, du molybdène ou du tungstène.

10. Procédé selon l'une des revendications précédentes,
**caractérisé en ce que**
la première couche (2) vaporisée par magnétrons présente une épaisseur d'au moins 1 µm.

11. Procédé selon l'une des revendications précédentes,
**caractérisé en ce que**
la première couche (2) vaporisée par magnétrons présente une épaisseur de 20 µm au maximum.

12. Procédé selon l'une des revendications précédentes,
**caractérisé en ce que**
la deuxième couche (3) appliquée par évaporation à décharge d'arc sous vide commandée par laser comprend plusieurs couches métalliques (8, 9, 10) et couches en carbone (11, 12, 13) disposées en alternance.

13. Procédé selon l'une des revendications précédentes,
**caractérisé en ce que**
le métal d'au moins une couche métallique (8, 9, 10) de la deuxième couche (3) appliquée par évaporation à décharge d'arc sous vide commandée par laser est un métal du groupe III-B, IV-A, V-A ou VI-A de la classification périodique des éléments.

14. Procédé selon la revendication 13,
**caractérisé en ce que**
le métal du groupe III-B est de l'aluminium.

15. Procédé selon la revendication 13,
**caractérisé en ce que**
le métal du groupe IV-A est du titane.

16. Procédé selon la revendication 13,
**caractérisé en ce que**
le métal du groupe V-A est du tantale.

17. Procédé selon la revendication 13,
**caractérisé en ce que**
le métal du groupe VI-A est du chrome, du molybdène ou du tungstène.

18. Procédé selon l'une des revendications précédentes,
**caractérisé en ce que**
la deuxième couche (3) appliquée par évaporation à décharge d'arc sous vide commandée par laser présente une épaisseur d'au moins 50 nm.

19. Procédé selon l'une des revendications précédentes,
**caractérisé en ce que**
la deuxième couche appliquée par évaporation à décharge d'arc sous vide commandée par laser présente une épaisseur de 5 µm au maximum.

20. Procédé selon l'une des revendications précédentes,
**caractérisé en ce que**
l'élément en métal léger (1) à revêtir est en aluminium, en magnésium ou en titane ou en un alliage d'aluminium, de magnésium ou de titane.
